Europäisches Patentamt

(19) European Patent Office

Office européen des brevets

(11) Publication number: **0 107 851**
**A1**

(12) # EUROPEAN PATENT APPLICATION

(21) Application number: **83110612.5**

(22) Date of filing: **24.10.83**

(51) Int. Cl.³: **H 01 L 21/265**
**H 01 L 29/72**

(30) Priority: **29.10.82 US 437701**

(43) Date of publication of application:
**09.05.84 Bulletin 84/19**

(84) Designated Contracting States:
**DE FR GB IT NL**

(71) Applicant: TEKTRONIX, INC.
D/S Y3-121 4900 S.W. Griffith Drive P.O. Box 500
Beaverton Oregon 97077(US)

(72) Inventor: Pickett, James M.
4707 S.W. Campbell Court
Portland Oregon 97201(US)

(74) Representative: Baillie, Iain Cameron et al,
c/o Ladas & Parry Isartorplatz 5
D-8000 München 2(DE)

(54) **Manufacture of semiconductor devices by the planar method.**

(57) A bipolar transistor is manufactured from a substrate of semiconductor material having at its main face a passivation layer defining a window through which an elongate area of the main face is exposed. A layer of passivating material is provided over a strip-form portion of the substrate intersecting the elongate area between its ends. The passivation layer defining the window is extended over portions of the elongate area that are not covered by the layer of passivating material. The layer of passivating material is removed so as to expose a portion of the elongate area corresponding substantially to its intersection with the strip-form portion of the substrate. Impurity atoms are introduced into the substrate so as to form within the region of semiconductor material underlying the intersection of the elongate area and the strip-form portion a region of semiconductor material of a first conductivity type. Further impurity atoms are introduced into the substrate so as to form within the region of semiconductor material of the first conductivity type a region of semiconductor material of the second conductivity type.

Fig.7A.

Fig.7B.

Fig.8.

# MANUFACTURE OF SEMICONDUCTOR DEVICES
# BY THE PLANAR METHOD

This invention relates to the manufacture of semiconductor devices by the planar method.

The planar method of producing a bipolar transistor is well known, and, in its simplest form, involves starting with a substrate of a semiconductor material, implanting impurity atoms into a main face of the substrate so as to produce a sub-surface zone of, for example, n type material, implanting further impurity atoms into the sub-surface region to produce a zone of p type material within the larger zone of n type material, and implanting still further impurity atoms into the p type zone to produce a zone of n type material within the larger zone of p type material. Ohmic contacts are made to the n type and p type materials of the several zones and form the collector, base and emitter electrodes of the transistor. In order to permit production of a small transistor (which is desirable in order to obtain a high density of transistors on an IC chip and a short response time for the individual transistors), it is necessary that the individual features of the transistor should be small, e.g., the linear dimensions of the emitter zone (the smaller zone of n type material in the above example) might be about 0.7 μm. Hitherto this has entailed use of masks with comparably small features, which masks have had to be accurately aligned and placed in registration to small tolerances. Accordingly, manufacture of very small bipolar transistors has hitherto been a difficult task.

The present invention may be used to manufacture a bipolar transistor with very small features (as small as 0.5 μm) using standard contact or projection lithography techniques and employing masks having

-2-

features which are considerably larger than the transistor's features and without its being necessary to place and align the masks to high accuracy.

For a better understanding of the invention, and to show how the same may be carried into effect, reference will now be made, by way of example, to the accompanying drawings in which:

Figs. 1, 2(a), 3, 4(a), 5(a), 6(a), 7(a), 8, 9(a), 10(a) and 11(a) are sectional views of a body of semiconductor material at successive stages of a method of manufacturing a bipolar transistor using the planar method;

Figs. 2(b), 4(b), 5(b), 6(b), 7(b), 9(b), 10(b) and 11(b) are top plan views of the body of semiconductor material at the stages illustrated, in sectional view, in Figs. 2(a), 4(a), 5(a), 6(a), 7(a), 9(a), 10(a) and 11(a) respectively.

In the sectional views, details out of the plane of the section are not shown.

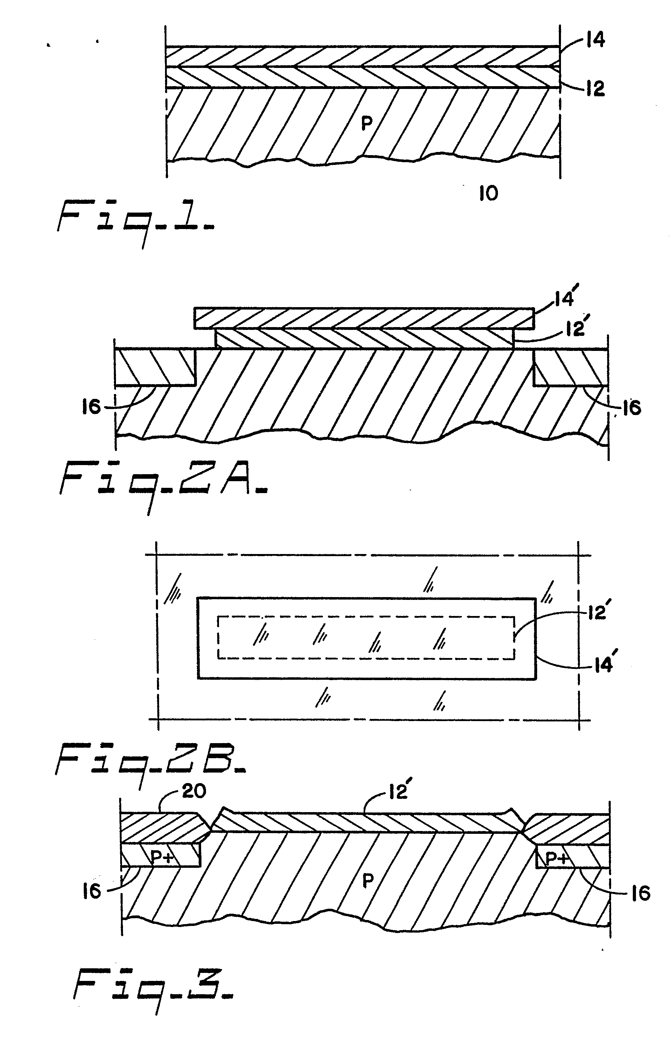

The first step in making a transistor using the planar method is selection of an appropriate semiconductor substrate. In this case, a silicon substrate 10 doped with an impurity of a kind and concentration such as to result in its having p type conductivity is selected. A layer 12 of CVD silicon nitride is deposited on a main face of the substrate 10, and a layer 14 of CVD silicon dioxide is deposited on top of the layer 12, as shown in FIG. 1. A layer of photoresist (not shown) is deposited on top of the oxide layer 14, and an elongate rectangular bar-shaped area of the photoresist is exposed. Typically, the rectangular area is approximately 12 μm long by 2.5 μm wide.

The unexposed photoresist is removed, and the silicon dioxide that was exposed by removal of photoresist is removed by etching with hydrofluoric acid. Silicon nitride is not affected by hydrofluoric acid. This first etching operation results in establishment of an island 14' (Fig. 2) of silicon dioxide on top of the layer 12 of silicon nitride. The silicon nitride is then etched with hot phosphoric acid, which affects neither the silicon dioxide of the island 14' nor the silicon of the substrate 10. Therefore the second etching operation results in removal of the silicon nitride that was exposed by removal of silicon dioxide and, in addition, removal of silicon nitride under the margin of the island 14' of silicon dioxide (undercutting) so that the margin of the island 14' over-hangs the boundary of the resulting island 12' of silicon nitride. The size of the overhang is controllable by controlling the thickness of the silicon nitride layer and the conditions of the second etching operation, particularly the etching time. The main face of the silicon substrate 10 is exposed around the island 12', 14'.

After the removal of silicon dioxide and silicon nitride by etching, a field implant is performed to establish a channel-breaking region 16 of p+ type material surrounding the island 12', 14'. This is done in order to prevent establishment of a layer of n type material in the substrate by inversion of the p type material when the substrate is thermally oxidized. Such a layer of n type material is undesirable because it would provide a conductive channel between the devices formed on the substrate.

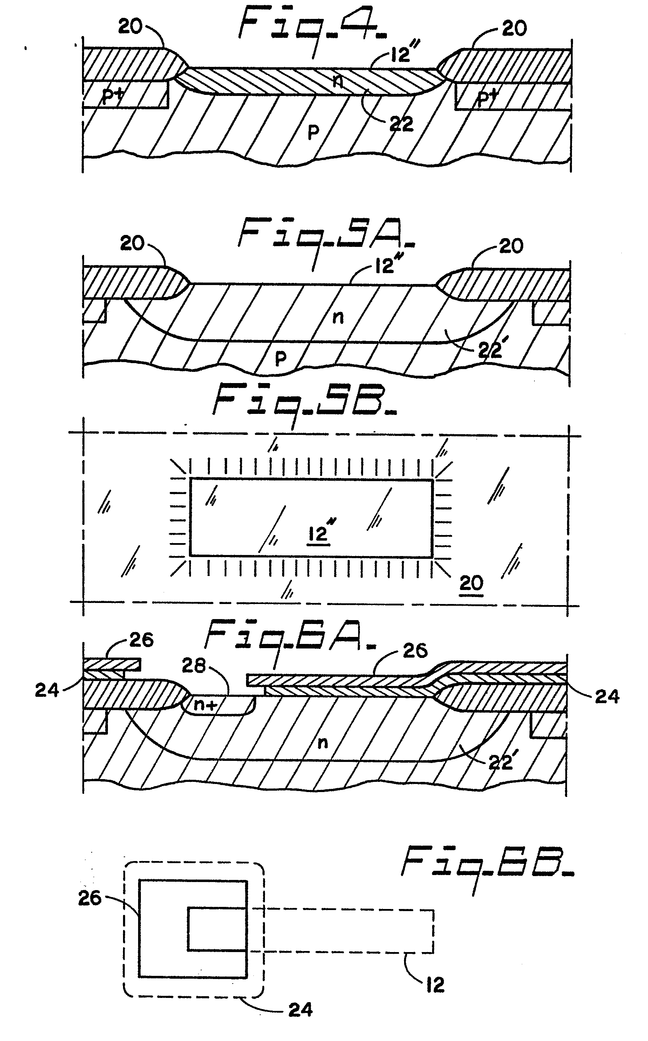

The remaining photoresist is then removed and the island 14' of silicon dioxide is removed by etching, leaving only the island 12' of silicon nitride on the surface of the substrate 10. The substrate is then thermally oxidized, resulting in formation of a layer 20 of silicon dioxide which extends over the field silicon surrounding the island 12' and in a bird's beak under the margin of the island 12' (Fig. 3). The island 12' is then removed by etching, exposing a rectangular area 12" of the substrate 10 (Fig. 4) which is approximately 11 μm long by 1.5 μm wide, and the area 12" is implanted with phosphorus using a 350 keV acceleration potential and a dose of $2x10^{12}$ $cm^{-2}$, so as to result in establishment, in the substrate 10, of a region 22 of n type conductivity. The silicon dioxide layer 20 acts as a mask to the phosphorus ions. The substrate is then heated to 1100°C for a period of 6 hours in order to drive the phosphorus atoms more deeply into the substrate and thus provide a larger n type region 22' within the substrate (Fig. 6). The region 22' ultimately becomes the collector of the transistor.

Further layers 24 and 26 of silicon nitride and silicon dioxide are deposited by chemical vapor deposition on the main face of the substrate 10, and the layer 24 and 26 are selectively etched using a mask having a square opaque feature surrounded by a transparent field. The mask is disposed so that one end (the left end shown in the drawings) of the rectangular area 12" of the substrate is located within the boundary of the image of the square mask feature. The CVD oxide is thus removed from a square zone at the left end of the area 12", and the CVD nitride exposed by removal of the CVD oxide is also removed. As before, the nitride is removed from underneath the margin of the oxide, leaving a ledge of oxide overhanging the surface of the substrate. The substrate is then implanted with arsenic using an acceleration potential of 120 keV and a dose of $1x10^{14}$ $cm^{-2}$, so as to result in the production, within the region 22', of a region 28 of n+ type conductivity at the left end of the area 12". Silicon dioxide serves as a mask to the implantation operation, so that the right edge of the region 28 is spaced from the edge of the silicon nitride layer 24. The n+ region 28 is ultimately used to form the collector contact zone of the transistor.

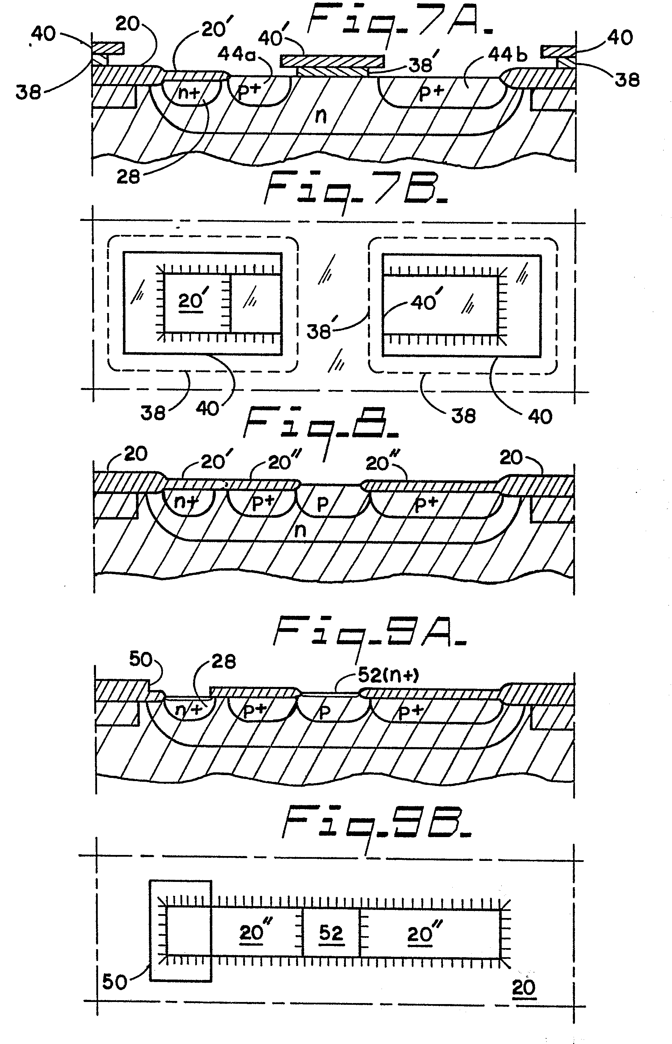

Following the n+ collector contact implant, the layer 26 of CVD oxide is removed and the main face of the substrate is again thermally oxidized, resulting in extension of the layer 20 of silicon dioxide over the surface of the substrate exposed through the opening in the nitride layer 24, as shown at 20' in Fig. 7. The layer 24 of silicon nitride is then removed.

Layers of silicon nitride and silicon dioxide 38 and 40 are deposited a third time by chemical vapor deposition over the main face of the substrate, and these layers are selectively etched using a mask which has transparent areas defining an opaque strip approximately 2 μm wide extending perpendicular to the longitudinal dimension of the rectangular area 12". In fact, the strip is defined between adjacent ends of two opaque rectangles which are sized and shaped so that the two ends of the area 12" are within the images of the opaque rectangles respectively. The CVD oxide is removed from the two rectangular areas corresponding to the opaque rectangles of the mask, and the CVD nitride that is exposed by removal of the CVD oxide is also removed. The nitride is removed from under the margin of the oxide, leaving a ledge of oxide overhanging the surface of the substrate. This etching operation therefore leaves a strip 38, of silicon nitride about 1 μm wide and a strip 40' of silicon dioxide about 2 μm wide crossing the rectangular area 12", between the oxide layer 20' and the right end of the rectangular area (Fig. 7).

The two exposed surfaces of the substrate, i.e., the two regions which are separated by the strip 38', 40', are then implanted with boron using an acceleration voltage of 25 keV and a dose of $1 \times 10^{15}$ cm$^{-2}$, so as to result in formation of two smaller regions 44a, 44b of p+ type material within the region 22'. As before, the shelf of silicon dioxide overhanging the silicon nitride serves as a mask, so that the edges of the regions 44a, 44b are spaced from the corresponding edges of the strip 38'. The region 44b ultimately becomes the base connection zone of the transistor.

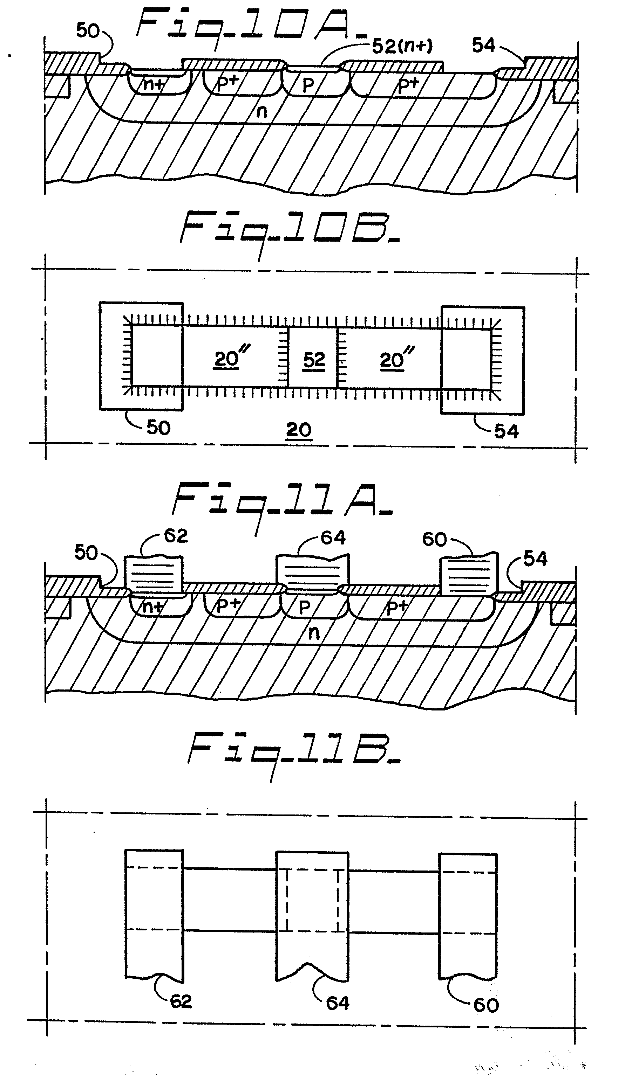

The oxide layer 40 is then removed, and the substrate is again thermally oxidized, resulting in extension of the layer of silicon dioxide over the regions 44 to the edges of the strip 38' as shown in Fig. 9 at 20". The silicon nitride layer 38 is then removed, exposing an approximately square area 46 of the substrate surface which bounds the zone 22'. This exposed area 46 of the substrate is then implanted with boron using an acceleration potential of 25 keV and a dose of $5.25 \times 10^{12}$ cm$^{-2}$, resulting in formation within the region 22' of a region 48 of p type material. The region 48 merges at its edges with the regions 44a, 44b. A part of the region 48 ultimately becomes the base of the transistor.

It will be understood that the entire main face of the substrate 10, other than the region 48 is covered with thermally-formed silicon dioxide. However, the covering is not of uniform thickness. The areas 20" of the covering shown in Fig. 8 are thinner than the other areas. A collector pre-ohmic mask, defining a rectangular aperture, is used to define a corresponding rectangular area 50 of the thermally-formed silicon dioxide layer and the thermally-formed

BAD ORIGINAL

silicon dioxide is then removed by etching to a depth sufficient to expose the collector contact zone as shown in FIG. 10. A further implant operation is then performed using arsenic with an acceleration potential of 40 keV and a dose of $3.25 \times 10^{15}$ $cm^{-2}$, resulting in establishment of an n+ region 52 within the region 48 and in reduction of the resistance of the collector contact region 28. The n+ region 52 has no common boundary with the region 44a or 44b. The region 52 becomes the emitter of the transistor.

At this stage of the process, all implantations have been effected and the various regions of the transistor have been established. Accordingly, the substrate is then annealed in order to repair crystal defects. A base pre-ohmic mask, defining a rectangular aperture, is used to define a corresponding rectangular area 54 of the thermally-formed oxide layer, and the thermally-formed oxide is removed by etching to a depth sufficient expose the region 44b, as shown in Fig. 10. A layer of metal is then deposited over the substrate, to establish ohmic contact with the base and collector contact zones and the emitter zone, and portions thereof are removed by photoetching to provide discrete base, collector and emitter electrodes 60, 62 and 64, as shown in FIG. 12.

It will be seen from the foregoing that a transistor structure having features as small as 0.5 μm x 0.7 μm can be produced using masks with features no smaller than 2 μm. This is achieved by use of masks which define strips at least 2 μm wide to pattern the silicon nitride and silicon dioxide layers, orienting the strips of the successively applied masks in crossing relationship and undercutting the nitride layers by a controlled amount. The cross-wise orientation of the masks also allows for relatively wide alignment tolerances, in that the mask used to pattern the layers 24 and 26 can be placed anywhere such that the left end of the rectangular area 12" is exposed by removal of the oxide and nitride within the area defined by the mask; the mask used to pattern the layers 38 and 40 can be placed anywhere such that the left edge of the strip 38' is to the right of the layer 20' and the right edge of the strip 40' is sufficiently to the left of the right end of the area 12" to ensure that the region 44b will be at least as wide (from left to right as seen in the drawings) as the intended base electrode 60; and the masks used to pattern the thermally-grown silicon dioxide can be placed anywhere such that removal of the silicon dioxide from the areas defined by the masks result in exposure of the regions 28 and 44b, and that the metal that is deposited in these areas will be spaced from the regions 44a and 52 respectively by silicon dioxide that remains.

It will be appreciated that the present invention is not restricted to the particular method and device which have been described and illustrated, since variations may be made therein without departing from the scope of the invention as defined in the appended claims, and equalivants thereof.

Claims:

1.  A method of manufacturing a bipolar transistor utilizing a substrate (10) of semiconductor material having at a main face thereof a passivation layer (20) defining a window through which an elongate area (12") of said main face is exposed, there being within the substrate and bounded by said elongate area of the main face a region (22') of semiconductor material of one conductivity type, the method comprising:

(a)  providing a layer of passivating material (38', 40') over a strip-form portion of the substrate, said strip-form portion intersecting said elongate area between the ends thereof;

(b)  extending the passivation layer defining the window over portions of the elongate area that are not covered by the layer provided in step (a);

(c)  removing the layer provided in step (a) so as to expose a portion (46) of said elongate area corresponding substantially to its intersection with said strip-form portion of the substrate;

(d)  introducing impurity atoms into the substrate by an ion implantation operation so as to form within the region of semiconductor material of said one conductivity type a region (48) of semiconductor material of the opposite conductivity type, said passivation layer acting as a mask to the ion implantation operation;

(e)  introducing impurity atoms into the substrate by an ion implantation operation so as to form within the region of semiconductor material of said opposite conductivity type a region (52) of semiconductor material of said one conductivity type, said passivation layer acting as a mask to the ion implantation operation.

2.  A method of manufacturing a semiconductor device utilizing a substrate of semiconductor material having at a main face thereof a passivation layer defining a window through which a preselected area (12") of said main face is exposed, there being within the substrate and bounded by said preselected area of said main face a region (22') of semiconductor material of one conductivity type, the method comprising:

(a) providing a layer (24) of a first passivating material over a first portion of said preselected area and leaving exposed a second portion of said preselected area and providing a layer (26) of a second passivating material over the layer of said first passivating material, the layer of the second passivating material extending in an overhang over the second portion of the preselected area beyond the boundary of the layer of the first passivating material by a predetermined amount;

(b) introducing impurity atoms into the substrate by an ion implantation operation so that a region (28) of the substrate that contains impurity is formed, said passivation layer and said second passivating material acting as masks to the ion implantation operation, so that said region is bounded at its edge by the passivation layer and is spaced from the layer of the first passivating material by a distance which depends on said predetermined amount;

(c) extending the passivation layer over said second portion of said preselected area (20');

(d) removing the layer of the first passivating material;

(e) removing the layer of the second passivating material, so as to expose a portion of said preselected area corresponding substantially to said first portion;

(f) providing a layer of passivating material (38, 40) over a portion of the area exposed in step (e);

(g) extending the passivation layer over portions of the preselected area that are not covered by the layer provided in step (f) (20");

(h) removing the layer provided in step (f) so as to expose a portion of said preselected area corresponding substantially to the region covered by the layer of passivating material provided in step (f);

(i) introducing impurity atoms into the substrate by an ion implantation operation so as to form within the region of semiconductor material of said one conductivity type at least a region (48) of semiconductor material of the opposite conductivity type, said passivation layer acting as a mask to the ion implantation operation.

3.    A method according to claim 2, wherein said preselected area is elongate and the portion of the area exposed in step (e) which is provided with a layer of passivating material in step (f) is a strip-form portion having its longitudinal dimension disposed transversley with respect to the longitudinal dimension of said preslected area.

0107851

Fig_1.

Fig_2A.

Fig_2B.

Fig_3.

Fig_4_

20  20

12"

P+  P+

n

P  22

Fig_5A_

20  20

12"

n

P  22'

Fig_5B_

12"

20

Fig_6A_

26  26

28

24  24

n+

n  22'

Fig_6B_

26

12

24

Fig.7A.

Fig.7B.

Fig.8.

Fig.9A.

Fig.9B.

**Fig.10A.**

50    52(n+)    54

**Fig.10B.**

20″    52    20″
50    20    54

**Fig.11A.**

62    64    60
50    54

**Fig.11B.**

62    64    60

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | FR-A-2 372 511   (CIE GENERALE D'ELECTRICITE) <br> * Claims 1, 2, 5; page 2, line 39 - page 5, line 25; figures 1-7 * | 1,2 | H 01 L   21/265 <br> H 01 L   29/72 |
| A | US-A-4 244 752   (BURROUGHS) <br> * Column 3, lines 11-39; figures 3, 4 * | 1,2 | |
| A | US-A-4 168 999   (FAIRCHILD) <br> * Column 3, line 64 - column 5, line 62; figures 5-10 * | 1,2 | |
| A | DE-A-2 804 525   (SIEMENS) <br> * Claim 1; page 21; figures 5A, 5B, 7B * | 1,2 | |

TECHNICAL FIELDS
SEARCHED (Int. Cl. ³)

H 01 L   21/00
H 01 L   21/265
H 01 L   29/72

The present search report has been drawn up for all claims

| Place of search <br> BERLIN | Date of completion of the search <br> 13-01-1984 | Examiner <br> ROTHER  A H J |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82